# EUROPÄISCHE PATENTSCHRIFT

(11) **EP 2 909 935 B1**
(45) Veröffentlichungstag und Bekanntmachung des Hinweises auf die Patenterteilung: **18.07.2018**
(21) Anmeldenummer: 13777272.9
(22) Anmeldetag: 15.10.2013
(51) Int. Cl.: H03K 4/02, H03K 17/082

(54) **VERFAHREN UND SCHALTUNGSANORDNUNG ZUM ANSTEUERN EINES HALBLEITERSCHALTERS**
METHOD AND CIRCUIT ARRANGEMENT FOR ACTUATING A SEMICONDUCTOR SWITCH
PROCÉDÉ ET CIRCUIT POUR LA COMMANDE D'UN COMMUTATEUR STATIQUE

(30) Priorität: 22.10.2012 DE 102012219240
(43) Veröffentlichungstag der Anmeldung: 26.08.2015
(73) Patentinhaber: Conti Temic Microelectronic GmbH, 90411 Nürnberg (DE)
(72) Erfinder: BLEY, Ulrich, 04519 Rackwitz (DE); HORNSTEIN, Christoph, 90461 Nürnberg (DE); KÜHNEN, Kai, 90491 Nürnberg (DE); TAISTRA, Eric, 90482 Nürnberg (DE)
(74) Vertreter: Bonn, Roman Klemens
(86) Internationale Anmeldenummer: PCT/EP2013/071506
(87) Internationale Veröffentlichungsnummer: WO 2014/063957

(56) Entgegenhaltungen:
- WO-A1-01/22585
- DE-C1- 19 855 604
- US-A1- 2009 027 096
- US-A1- 2011 241 738
- US-A1- 2012 206 123

## Beschreibung

Die Erfindung betrifft ein Verfahren und eine Schaltungsanordnung zum Ansteuern eines steuerbaren Halbleiterschalters.

Aus der DE 43 01 605 C1 sind ein Verfahren und eine Anordnung zum Überwachen des Ein- und Ausschaltens eines steuerbaren Leistungshalbleiterbauelements in einer leistungselektronischen Schaltung bekannt. Steuersignale für das Leistungshalbleiterbauelement werden einer Gate-Elektrode galvanisch entkoppelt zugeführt. Bei einem Ansteuerungssignal zur Einschaltung des Leistungshalbleiterbauelements werden aus Pegelwechseln des die Gate-Elektrode beaufschlagenden Signals und den Pegelwechseln an einer Ausgangselektrode beim Umschalten des Leistungshalbleiterbauelements Zählsignale gebildet. Die Zählsignale werden aufsummiert und mit einem der einwandfreien Arbeitsweise des Leistungshalbleiterbauelements zugeordneten, vorgegebenen Zählwert verglichen. Bei einem Unterschied zwischen der Summe der Zählsignale und dem vorgegebenen Zählwert wird ein Fehler gemeldet.

In der Druckschrift US 2009/0027096 A1 wird eine Antriebssteuerung beschrieben, in der ein Kondensator mit parallel geschaltetem Widerstand während einer Vorladephase mittels einem Strom proportional zur Drain-Source-Spannung aufgeladen wird, die über einem zu schützenden MOSFET abfällt. Der Kondensator soll zusammen mit dem Widerstand die thermische Wärmekapazität des Transistors wiedergeben und wird nur geladen, wenn der MOSFET nicht vollständig angeschaltet ist, da der MOSFET im nicht vollständig angeschalteten Zustand (R > R_DS, on, linearer Betrieb) besonders viel Wärme erzeugt. Ist der MOSFET vollständig geladen, wird der Kondensator langsam entladen (entsprechend einer fallenden Temperatur des MOSFETs in AN-Zustand). Folgen Phasen des linearer Betriebs (d.h. Phasen, in denen der MOSFET nicht vollständig angeschaltet ist) in kurzer Zeitspanne hintereinander, dann folgen auch die Ladephasen häufig aufeinander, so dass sich der Kondensator mit der Zeit mehr und mehr auflädt. Ein Überschreiten eines Grenzwerts entspricht der Überhitzung durch häufige Schaltphasen (in denen der Transistor linear betrieben wird), entsprechend der in kurzer Zeit kummulierten (und nicht abgeführten) Wärme im MOSFET. Das Verfahren der US 2009/0027096 A1 überwacht somit die Temperatur durch häufiges Schalten in kurzem Zeitraum anhand einer Nachbildung, die einer Parallelschaltung eines Kondensators und eines Widerstands entspricht. In einer Zeitspanne, in der nicht geschaltet wird, ist die Ladestromquelle des Kondensators ausgeschaltet, so dass durch Fehler ausgelöste, besonders lange Phasen ohne Schaltvorgang nicht durch den Kondensator und dessen Parallelwiderstand erkannt werden.

Aufgabe der Erfindung ist es, ein Verfahren und eine Schaltungsanordnung zum Ansteuern eines steuerbaren Halbleiterschalters anzugeben, welche eine erhöhte Betriebssicherheit für den Betrieb des Halbleiterschalters ermöglichen.

Diese Aufgabe wird mit dem Gegenstand der unabhängigen Ansprüche gelöst. Vorteilhafte Weiterbildungen ergeben sich aus den abhängigen Ansprüchen.

Ein Verfahren zum Ansteuern eines steuerbaren Halbleiterschalters mit einem Steuersignal durch gesteuertes, phasenweises Ein- und Ausschalten weist gemäß einem Aspekt der Erfindung folgende Schritte auf. Es erfolgt ein Starten einer Zeitmessung zu Beginn zumindest einer Phase des phasenweisen Ein- und Ausschaltens zur Ermittlung einer Zeitdauer, wobei die Zeitmessung mindestens solange fortgesetzt wird, bis eine auf die zumindest eine Phase folgende Phase des phasenweisen Ein- und Ausschaltens beginnt. Zudem erfolgt ein Vergleichen der ermittelten Zeitdauer mit einer vorgegebenen maximalen Zeitdauer. Falls die ermittelte Zeitdauer die vorgegebene maximale Zeitdauer überschreitet, erfolgt ein Ansteuern des Halbleiterschalters derart, dass der Halbleiterschalter in einen vorgegebenen Betriebszustand geschaltet wird.

Unter einem phasenweisen Ein- und Ausschalten wird dabei ein schrittweises Ein- beziehungsweise Ausschalten des Halbleiterschalters verstanden, d.h. das Ein- beziehungsweise Ausschalten des Halbleiterschalters weist zumindest zwei zeitlich voneinander unterschiedliche Schritte auf, welche voneinander unabhängige Ansteuerparameter aufweisen, wie im Folgenden weiter erläutert wird.

Hierbei wird mit einem Ein- bzw. Ausschalten des Halbleiterschalters jeweiligen einzelnen Ein- bzw. Ausschaltvorgang des Halbleiterschalters gemeint, wobei in einem Einschaltvorgang der Halbleiterschalter von einem anfänglichen offenen Schaltzustand zu einem geschlossenen Schaltzustand übergeht und in einem Ausschaltvorgang von einem anfänglichen geschlossenen Schaltzustand zu einem offenen Schaltzustand übergeht.

Das Verfahren gemäß der genannten Ausführungsform ermöglicht eine erhöhte Betriebssicherheit für den Betrieb des Halbleiterschalters. Dies erfolgt insbesondere durch das Starten einer Zeitmessung zu Beginn zumindest einer Phase des phasenweisen Ein- und Ausschaltens und das Fortsetzen der Zeitmessung, bis eine auf die zumindest eine Phase folgende Phase des phasenweisen Ein- und Ausschaltens beginnt, das Vergleichen der ermittelten Zeitdauer mit einer vorgegebenen maximalen Zeitdauer sowie das Schalten des Halbleiterschalters in einen vorgegebenen Betriebszustand bei Überschreiten der vorgegebenen maximalen Zeitdauer. Es wird somit die Zeitdauer zumindest einer der Phasen des phasenweisen Ein- und Ausschaltens ermittelt und mit einer vorgegebenen maximalen Zeitdauer verglichen und bei Überschreiten der vorgegebenen maximalen Zeitdauer der Halbleiterschalter in einen vorgegebenen Betriebszustand geschaltet. Dabei wird von der Überlegung ausgegangen, dass ein Überschreiten der vorgegebenen maximalen Zeitdauer auf einen Fehlerzustand schließen lässt und der Halbleiterschalter in diesem Fall in einen sicheren Betriebszustand in Form des vorgegebenen Betriebszustands gebracht werden soll.

Das genannte Verfahren ermöglicht somit eine höhere Fehlerrobustheit und Zuverlässigkeit. Die Überwachung des Schaltverhaltens sowie die Fehlerbehandlung erhöht die Zuverlässigkeit durch eine Reduzierung der Ausfallwahrscheinlichkeit des Halbleiterschalters. Ferner können Sicherheitsanforderungen für sicherheitsrelevante elektrische beziehungsweise elektronische Systeme insbesondere in Fahrzeug-Applikationen erfüllt werden. Zudem werden erweiterte Diagnosemöglichkeiten bereitgestellt.

Der vorgegebene Betriebszustand ist ein ausgeschalteter Betriebszustand des Halbleiterschalters. Dieser Betriebszustand stellt typischerweise einen sicheren Betriebszustand im Falle einer Fehlfunktion dar.

In einer Ausführungsform weist der Halbleiterschalter einen Steueranschluss, einen Eingangsstromanschluss sowie einen Ausgangsstromanschluss auf und ist über den Steueranschluss steuerbar. Ferner ist das Steuersignal ein pulsweiten moduliertes Steuersignal. Das Ansteuern des Halbleiterschalters erfolgt in der genannten Ausführungsform zudem mittels einer Treiberschaltungseinheit, wobei die Treiberschaltungseinheit einen ersten, zwischen dem Steueranschluss des Halbleiterschalters und einem ersten, negativen Versorgungsspannungsanschluss angeordneten, steuerbaren Treiberschalter und einen zweiten, zwischen dem Steueranschluss des Halbleiterschalters und einem zweiten, positiven Versorgungsspannungsanschluss angeordneten, steuerbaren Treiberschalter aufweist und das Ansteuern des Halbleiterschalters durch gesteuertes, phasenweises Ein- und Ausschalten des ersten Treiberschalters und des zweiten Treiberschalter erfolgt. Das Verfahren weist in dieser Ausführungsform zudem folgende Verfahrensschritte auf. Es erfolgt ein Erkennen einer ersten Art oder einer zweiten, von der ersten Art verschiedenen Art einer Signalflanke bei dem Steuersignal. Die erste Art der Signalflanke ist beispielsweise eine steigende Signalflanke und die zweite Art der Signalflanke eine fallende Signalflanke. Zudem erfolgen ein Messen einer Eingangsanschlussspannung an dem Eingangsstromanschluss des Halbleiterschalters und ein Vergleichen der gemessenen Eingangsanschlussspannung mit einer Referenzeingangsspannung. Dabei wird die Eingangsanschlussspannung an dem Eingangsstromanschluss des Halbleiterschalters vorzugsweise bezogen auf dem Spannungspotential an dem Ausgangsstromanschluss des Halbleiterschalters gemessen. In diesem Fall ist die Eingangsanschlussspannung eine Potentialdifferenz zwischen dem Spannungspotential an dem Eingangsstromanschluss und dem Spannungspotential an dem Ausgangsstromanschluss des Halbleiterschalters. Ferner erfolgen ein Messen einer Steueranschlussspannung an dem Steueranschluss des Halbleiterschalters und ein Vergleichen der gemessenen Steueranschlussspannung mit einer Referenzsteuerspannung. Dabei wird die Steueranschlussspannung an dem Steueranschluss des Halbleiterschalters vorzugsweise bezogen auf dem Spannungspotential an dem Ausgangsstromanschluss des Halbleiterschalters gemessen. In diesem Fall ist die Steueranschlussspannung eine Potentialdifferenz zwischen dem Spannungspotential an dem Steueranschluss und dem Spannungspotential an dem Ausgangsstromanschluss des Halbleiterschalters. Das Ansteuern des Halbleiterschalters erfolgt in dieser Ausführungsform durch gesteuertes, phasenweises Ein- und Ausschalten des ersten und des zweiten Treiberschalters abhängig von der erkannten, unmittelbar vorausliegenden ersten Art oder zweiten Art der Signalflanke bei dem Steuersignal und/oder abhängig von dem Vergleichsergebnis zwischen der aktuell gemessenen Eingangsanschlussspannung und der Referenzeingangsspannung und/oder abhängig von dem Vergleichsergebnis zwischen der aktuell gemessenen Steueranschlussspannung und der Referenzsteuerspannung.

Insbesondere kann das Ansteuern des Halbleiterschalters dabei durch gesteuertes, phasenweises Ein- und Ausschalten des ersten und des zweiten Treiberschalters wahlweise mit einer ersten vorgegebenen Ansteuerspannung, einer zweiten vorgegebenen Ansteuerspannung, einem ersten vorgegebenen Ansteuerstrom, einem zweiten, von dem ersten vorgegebenen Ansteuerstrom unabhängigen vorgegebenen Ansteuerstrom, einem dritten vorgegebenen Ansteuerstrom, einem vierten, von dem dritten vorgegebenen Ansteuerstrom unabhängigen vorgegebenen Ansteuerstrom oder einem fünften, dem ersten vorgegebenen Ansteuerstrom und dem zweiten vorgegebenen Ansteuerstrom gegenüber niedrigeren vorgegebenen Ansteuerstrom erfolgen. Beispielsweise ist der zweite vorgegebene Ansteuerstrom dem ersten vorgegebenen Ansteuerstrom gegenüber niedriger und der vierte vorgegebene Ansteuerstrom dem dritten vorgegebenen Ansteuerstrom gegenüber niedriger.

In den letztgenannten Ausführungsformen wird der Schaltvorgang des Halbleiterschalters somit in mehrere Phasen unterteilt, wobei die Umladung des Steueranschlusses des Halbleiterschalters in Abhängigkeit des jeweiligen Schaltzustands in bestimmten Schaltphasen über geregelte Stromquellen, deren Stromwert für jede Phase einzeln konfiguriert werden kann, sowie in den verbleibenden Schaltphasen über das Anlegen von vorgegebenen Spannungen erfolgt, wie im Folgenden weiter erläutert wird. Mit diesen Verfahren lassen sich die Schaltverluste gegenüber Treiberschaltungen, bei welchen der Steueranschluss über einen Vorwiderstand fest auf eine Einschalt- beziehungsweise Ausschalt-Spannung geklemmt wird, deutlich reduzieren.

In einer weiteren Ausführungsform des Verfahrens erfolgt in einer ersten Phase eines Einschaltens des Halbleiterschalters ein Ansteuern des zweiten Treiberschalters mit dem dritten vorgegebenen Ansteuerstrom und ein Starten einer ersten Zeitmessung zu Beginn der ersten Phase des Einschaltens zur Ermittlung einer ersten Zeitdauer bei einer erkannten, unmittelbar vorausliegenden ersten Art der Signalflanke bei dem Steuersignal. Die erste Zeitmessung wird dabei fortgesetzt, solange die aktuell gemessene Steueranschlussspannung die Referenzsteuerspannung nicht überschreitet. Falls die ermittelte erste Zeitdauer eine erste vorgegebene maximale Zeitdauer überschreitet, wird der zweite Treiberschalter ausgeschaltet und der erste Treiberschalter mit dem zweiten vorgegebenen Ansteuerstrom angesteuert.

Zudem erfolgt in einer weiteren Ausgestaltung in einer zweiten Phase des Einschaltens des Halbleiterschalters ein Ansteuern des zweiten Treiberschalters mit dem vierten Ansteuerstrom, ein Beenden der ersten Zeitmessung und ein Starten einer zweiten Zeitmessung zu Beginn der zweiten Phase des Einschaltens zur Ermittlung einer zweiten Zeitdauer bei Überschreiten der Referenzsteuerspannung durch die aktuell gemessene Steueranschlussspannung. Die zweite Zeitmessung wird fortgesetzt, solange die aktuell gemessene Eingangsanschlussspannung die Referenzeingangsspannung nicht unterschreitet. Falls die ermittelte zweite Zeitdauer eine zweite vorgegebene maximale Zeitdauer überschreitet, wird der zweite Treiberschalter ausgeschaltet und der erste Treiberschalter mit dem fünften vorgegebenen Ansteuerstrom angesteuert.

In der zweiten Phase des Einschaltens kann die erste Zeitmessung zudem fortgesetzt werden, falls die aktuell gemessene Steueranschlussspannung die Referenzsteuerspannung wieder unterschreitet. Falls die ermittelte erste Zeitdauer die erste vorgegebene maximale Zeitdauer überschreitet, wird der zweite Treiberschalter dabei ausgeschaltet und der erste Treiberschalter mit dem zweiten vorgegebenen Ansteuerstrom angesteuert.

In einer dritten Phase des Einschaltens des Halbleiterschalters erfolgt bevorzugt ein Ansteuern des zweiten Treiberschalters mit der zweiten vorgegebenen Ansteuerspannung und ein Beenden der zweiten Zeitmessung bei Unterschreiten der Referenzeingangsspannung durch die aktuell gemessene Eingangsanschlussspannung. Dabei wird in der dritten Phase des Einschaltens die Eingangsanschlussspannung wiederholt gemessen und mit der Referenzeingangsspannung verglichen. Falls die wiederholt gemessene Eingangsanschlussspannung die Referenzeingangsspannung überschreitet, wird der zweite Treiberschalter ausgeschaltet und der erste Treiberschalter mit dem fünften vorgegebenen Ansteuerstrom angesteuert.

In der dritten Phase des Einschaltens kann zudem die erste Zeitmessung fortgesetzt werden, falls die aktuell gemessene Steueranschlussspannung die Referenzsteuerspannung wieder unterschreitet. Falls die ermittelte erste Zeitdauer die erste vorgegebene maximale Zeitdauer überschreitet, wird dabei der zweite Treiberschalter ausgeschaltet und der erste Treiberschalter mit dem zweiten vorgegebenen Ansteuerstrom angesteuert.

In einer weiteren Ausführungsform des Verfahrens wird der erste Treiberschalter mit dem fünften vorgegebenen Ansteuerstrom für eine fünfte vorgegebene Zeitdauer angesteuert. Nach Erreichen der fünften vorgegebenen Zeitdauer wird die Steueranschlussspannung wiederholt gemessen und mit der Referenzsteuerspannung verglichen.

Der Steueranschluss wird dabei bevorzugt über einen elektrischen Widerstand mit dem negativen Versorgungsspannungsanschluss gekoppelt beziehungsweise elektrische verbunden, falls die wiederholt gemessene Steueranschlussspannung die Referenzsteuerspannung nach Erreichen der fünften vorgegebenen Zeitdauer nicht unterschreitet. Falls die wiederholt gemessene Steueranschlussspannung die Referenzsteuerspannung hingegen nicht überschreitet und zudem eine unmittelbar vorausliegende zweite Art der Signalflanke bei dem Steuersignal erkannt wird, wird der erste Treiberschalter mit der ersten vorgegebenen Ansteuerspannung angesteuert.

In einer ersten Phase des Ausschaltens des Halbleiterschalters erfolgt in einer weiteren Ausgestaltung des Verfahrens ein Ansteuern des ersten Treiberschalters mit dem ersten vorgegebenen Ansteuerstrom und ein Starten einer dritten Zeitmessung zu Beginn der ersten Phase des Ausschaltens zur Ermittlung einer dritten Zeitdauer bei einer erkannten, unmittelbar vorausliegenden zweiten Art der Signalflanke bei dem Steuersignal. Die dritte Zeitmessung wird fortgesetzt, solange die aktuell gemessene Steueranschlussspannung die Referenzsteuerspannung nicht unterschreitet. Falls die ermittelte dritte Zeitdauer eine dritte vorgegebene maximale Zeitdauer überschreitet, wird der Steueranschluss über einen elektrischen Widerstand mit dem negativen Versorgungsspannungsanschluss gekoppelt beziehungsweise elektrische verbunden.

Bevorzugt erfolgt in einer zweiten Phase des Ausschaltens des Halbleiterschalters ein Ansteuern des ersten Treiberschalters mit dem zweiten vorgegebenen Ansteuerstrom und ein Starten einer vierten Zeitmessung zu Beginn der zweiten Phase des Ausschaltens des Halbleiterschalters zur Ermittlung einer vierten Zeitdauer bei Überschreiten der Referenzeingangsspannung durch die aktuell gemessene Eingangsanschlussspannung. Die vierte Zeitmessung wird fortgesetzt, solange die aktuell gemessene Steueranschlussspannung die Referenzsteuerspannung nicht unterschreitet. Falls die ermittelte vierte Zeitdauer eine vierte vorgegebene maximale Zeitdauer überschreitet, wird der Steueranschluss über einen elektrischen Widerstand mit dem negativen Versorgungsspannungsanschluss gekoppelt beziehungsweise elektrische verbunden.

In einer dritten Phase des Ausschaltens des Halbleiterschalters erfolgt in einer weiteren Ausführungsform des Verfahrens ein Ansteuern des ersten Treiberschalters mit der ersten vorgegebenen Ansteuerspannung bei Unterschreiten der Referenzsteuerspannung durch die aktuell gemessene Steueranschlussspannung.

Die genannten Ausführungsformen, welche ein dreistufiges beziehungsweise dreiphasiges Ein- und Ausschalten des Halbleiterschalters betreffen, ermöglichen in vorteilhafter Weise eine Fehlererkennung und eine entsprechende Fehlerreaktion durch eine zeitliche Überwachung der oben erläuterten Schaltphasen. Damit wird die Betriebssicherheit des Halbleiterschalters in besonderem Maße erhöht.

Die Erfindung betrifft zudem eine Schaltungsanordnung zum Ansteuern eines steuerbaren Halbleiterschalters mit einem Steuersignal. Die Schaltungsanordnung weist eine Ansteuereinheit zum Ansteuern des Halbleiterschalters durch gesteuertes, phasenweises Ein- und Ausschalten auf. Ferner weist die Schaltungsanordnung eine Zeitmesseinheit auf zum Starten einer Zeitmessung zu Beginn zumindest einer Phase des phasenweisen Ein- und Ausschaltens zur Ermittlung einer Zeitdauer, wobei die Zeitmessung mindestens solange fortgesetzt wird, bis eine auf die zumindest eine Phase folgende Phase des phasenweisen Ein- und Ausschaltens beginnt. Darüber hinaus weist die Schaltungsanordnung eine Vergleichseinheit zum Vergleichen der ermittelten Zeitdauer mit einer vorgegebenen maximalen Zeitdauer auf. Die Ansteuereinheit ist derart zum Ansteuern des Halbleiterschalters ausgebildet, dass der Halbleiterschalter in einen vorgegebenen Betriebszustand geschaltet wird, falls die ermittelte Zeitdauer die vorgegebene maximale Zeitdauer überschreitet.

Die Schaltungsanordnung weist die bereits im Zusammenhang mit dem entsprechenden Verfahren genannten Vorteile auf, welche an dieser Stelle zur Vermeidung von Wiederholungen nicht nochmals aufgeführt werden. Ferner eignet sich die Schaltungsanordnung insbesondere für die Durchführung des erfindungsgemäßen Verfahrens, wobei dies auch auf die Ausgestaltungen und Weiterbildungen zutreffen kann. Hierzu kann die Schaltungsanordnung weitere geeignete Vorrichtungen beziehungsweise Komponenten aufweisen.

In einer Ausführungsform weist der Halbleiterschalter einen Steueranschluss, einen Eingangsstromanschluss sowie einen Ausgangsstromanschluss auf und ist über den Steueranschluss steuerbar. Das Steuersignal ist dabei ein pulsweiten moduliertes Steuersignal. Die Schaltungsanordnung weist zudem eine, zumindest einen steuerbaren Treiberschalter aufweisende Treiberschaltungseinheit, eine erste Vergleichseinheit zum Messen einer Eingangsanschlussspannung an dem Eingangsstromanschluss des Halbleiterschalters und zum Vergleichen der gemessenen Eingangsanschlussspannung mit einer Referenzeingangsspannung und eine zweite Vergleichseinheit zum Messen einer Steueranschlussspannung an dem Steueranschluss des Halbleiterschalters und zum Vergleichen der gemessenen Steueranschlussspannung mit einer Referenzsteuerspannung auf. Die Ansteuereinheit ist in der genannten Ausführungsform zum Ansteuern des Halbleiterschalters durch gesteuertes, phasenweises Ein- und Ausschalten des zumindest einen Treiberschalters ausgebildet.

Der Halbleiterschalter ist beispielsweise als IGBT, insbesondere als n-Kanal IGBT, oder als MOSFET, insbesondere als n-Kanal MOSFET, ausbildet.

Die Treiberschaltungseinheit ist beispielsweise eine Halbbrückenschaltungseinheit.

Ferner betrifft die Erfindung einen Stromrichter zum Bereitstellen von zumindest einem Phasenstrom für eine elektrische Maschine, wobei der Stromrichter eine Schaltungsanordnung gemäß einer der genannten Ausführungsformen zum Bereitstellen des Phasenstromes aufweist.

Die Erfindung betrifft darüber hinaus eine Antriebsvorrichtung zum Antreiben eines Fahrzeugs mit einer elektrischen Maschine, wobei die Antriebsvorrichtung eine Schaltungsanordnung gemäß einer der genannten Ausführungsformen zum Bereitstellen von zumindest einem Phasenstrom für die elektrische Maschine aufweist.

Ausführungsformen der Erfindung werden nun anhand der beigefügten Figuren näher erläutert.
- Figur 1: zeigt eine schematische Darstellung eines Verfahrens zum Ansteuern eines einen Steueranschluss, einen Eingangsstromanschluss sowie einen Ausgangsstromanschluss aufweisenden, über den Steueranschluss steuerbaren Halbleiterschalters gemäß einer Ausführungsform;
- Figur 2: zeigt eine Antriebsvorrichtung zum Antrieb eines Elektro- oder Hybridfahrzeugs mit einer elektrischen Maschine und einem Stromrichter in einer schematischen Darstellung gemäß einer Ausführungsform.

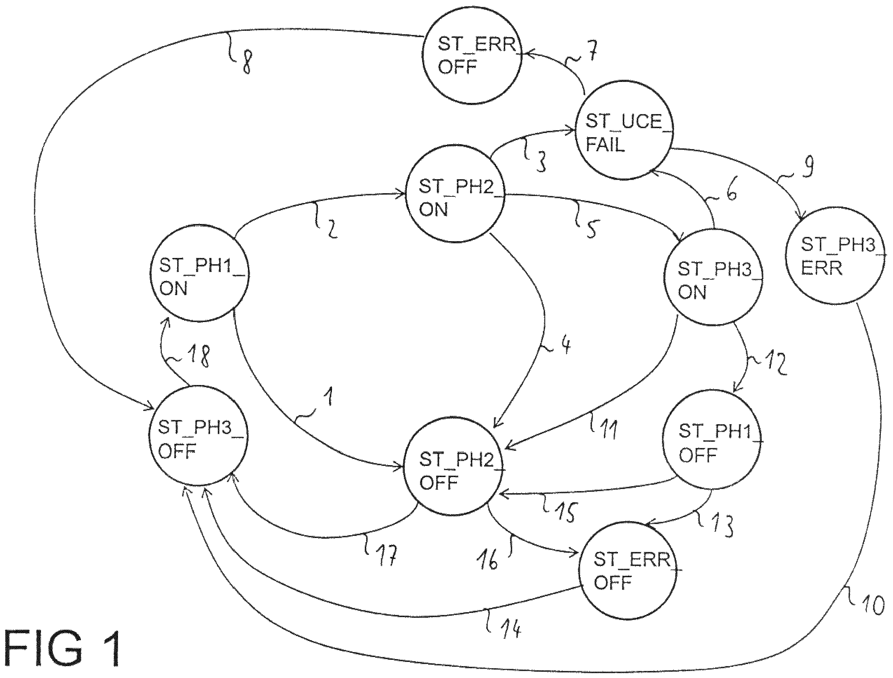

Figur 1 zeigt eine schematische Darstellung eines Verfahrens zum Ansteuern eines einen Steueranschluss, einen Eingangsstromanschluss sowie einen Ausgangsstromanschluss aufweisenden, über den Steueranschluss steuerbaren Halbleiterschalters mit einem pulsweiten modulierten Steuersignal und mittels einer Treiberschaltungseinheit gemäß einer Ausführungsform. Der Halbleiterschalter ist in der gezeigten Ausführungsform ein n-Kanal IGBT oder ein n-Kanal MOSFET.

In der gezeigten Ausführungsform beinhaltet das Verfahren bei einem fehlerfreien Betrieb drei Einschaltphasen des Halbleiterschalters, welche als ST_PH1_ON, ST_PH2_ON beziehungsweise ST_PH3_ON bezeichnet werden, sowie drei Ausschaltphasen des Halbleiterschalters, welche als ST_PH1_OFF, ST_PH2_OFF beziehungsweise ST_PH3_OFF bezeichnet werden. Die genannten Schaltphasen werden im Folgen näher erläutert.

Die Treiberschaltungseinheit weist einen ersten, zwischen dem Steueranschluss des Halbleiterschalters und einem ersten, negativen Versorgungsspannungsanschluss angeordneten, steuerbaren Treiberschalter und einen zweiten, zwischen dem Steueranschluss des Halbleiterschalters und einem zweiten, positiven Versorgungsspannungsanschluss angeordneten, steuerbaren Treiberschalter auf.

In der gezeigten Ausführungsform erfolgt ein Erkennen einer ersten Art oder einer zweiten, von der ersten Art verschiedenen Art einer Signalflanke bei dem pulsweiten modulierten Steuersignal. Die erste Art der Signalflanke ist beispielsweise eine steigende Signalflanke und die zweite Art der Signalflanke eine fallende Signalflanke. Zudem erfolgt ein Messen einer Eingangsanschlussspannung an dem Eingangsstromanschluss des Halbleiterschalters und ein Vergleichen der gemessenen Eingangsanschlussspannung mit einer Referenzeingangsspannung. Ferner erfolgt ein Messen einer Steueranschlussspannung an dem Steueranschluss des Halbleiterschalters und ein Vergleichen der gemessenen Steueranschlussspannung mit einer Referenzsteuerspannung. Das Ansteuern des Halbleiterschalters erfolgt in dieser Ausführungsform durch gesteuertes, phasenweises Ein- und Ausschalten des ersten und des zweiten Treiberschalters abhängig von der erkannten, unmittelbar vorausliegenden ersten Art oder zweiten Art der Signalflanke bei dem Steuersignal und/oder abhängig von dem Vergleichsergebnis zwischen der aktuell gemessenen Eingangsanschlussspannung und der Referenzeingangsspannung und/oder abhängig von dem Vergleichsergebnis zwischen der aktuell gemessenen Steueranschlussspannung und der Referenzsteuerspannung.

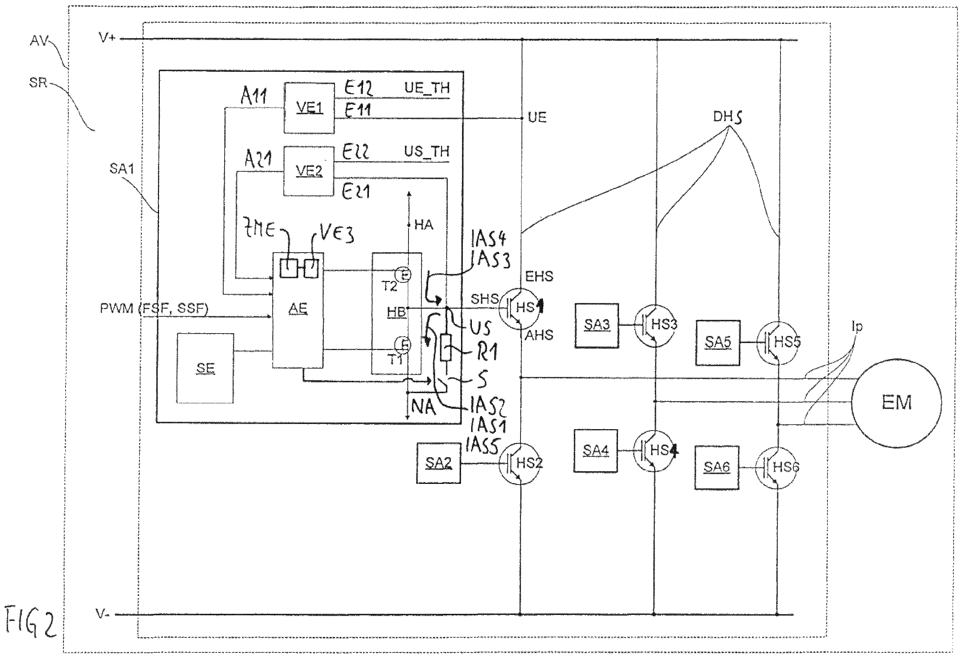

Das Ansteuern des Halbleiterschalters erfolgt dabei durch gesteuertes, phasenweises Ein- und Ausschalten des ersten und des zweiten Treiberschalters wahlweise mit einer ersten vorgegebenen Ansteuerspannung, einer zweiten vorgegebenen Ansteuerspannung, einem ersten vorgegebenen Ansteuerstrom IAS1, einem zweiten, von dem ersten vorgegebenen Ansteuerstrom IAS1 unabhängigen vorgegebenen Ansteuerstrom IAS2, einem dritten vorgegebenen Ansteuerstrom IAS3, einem vierten, von dem dritten vorgegebenen Ansteuerstrom IAS3 unabhängigen vorgegebenen Ansteuerstrom IAS4 oder einem fünften, dem ersten vorgegebenen Ansteuerstrom IAS1 und dem zweiten vorgegebenen Ansteuerstrom IAS2 gegenüber niedrigeren vorgegebenen Ansteuerstrom IAS5. Beispielsweise ist der zweite vorgegebene Ansteuerstrom IAS2 dem ersten vorgegebenen Ansteuerstrom IAS1 gegenüber niedriger und der vierte vorgegebene Ansteuerstrom IAS4 dem dritten vorgegebenen Ansteuerstrom IAS3 gegenüber niedriger. Die genannten Ansteuerströme sind in Figur 2 dargestellt.

In der ersten Phase ST_PH1_ON des Einschaltens des Halbleiterschalters erfolgt ein Ansteuern des zweiten Treiberschalters mit dem dritten vorgegebenen Ansteuerstrom und ein Starten einer ersten Zeitmessung zu Beginn der ersten Phase ST_PH1_ON des Einschaltens zur Ermittlung einer ersten Zeitdauer bei einer erkannten, unmittelbar vorausliegenden ersten Art der Signalflanke bei dem Steuersignal. Die erste Zeitmessung wird dabei fortgesetzt, solange die aktuell gemessene Steueranschlussspannung die Referenzsteuerspannung nicht überschreitet.

Falls die aktuell gemessene Steueranschlussspannung die Referenzsteuerspannung nicht überschreitet und die ermittelte erste Zeitdauer eine erste vorgegebene maximale Zeitdauer überschreitet, wird der zweite Treiberschalter ausgeschaltet und der erste Treiberschalter mit dem zweiten vorgegebenen Ansteuerstrom angesteuert, wie dies in Figur 1 schematisch mit einem Übergang 1 dargestellt ist. Es erfolgt somit in diesem Fall ein Übergang von der ersten Phase ST_PH1_ON des Einschaltens zu der zweiten Phase ST_PH2_OFF des Ausschaltens des Halbleiterschalters.

Falls hingegen die aktuell gemessene Steueranschlussspannung die Referenzsteuerspannung überschreitet und die ermittelte erste Zeitdauer die erste vorgegebene maximale Zeitdauer dabei nicht überschreitet, erfolgt ein in Figur 1 schematisch dargestellter Übergang 2 von der ersten Phase ST_PH1_ON des Einschaltens zu der zweiten Phase ST_PH2_ON des Einschaltens des Halbleiterschalters.

In der zweiten Phase ST_PH2_ON erfolgt ein Ansteuern des zweiten Treiberschalters mit dem vierten Ansteuerstrom, ein Beenden der ersten Zeitmessung und ein Starten einer zweiten Zeitmessung zu Beginn der zweiten Phase des Einschaltens zur Ermittlung einer zweiten Zeitdauer. Die zweite Zeitmessung wird fortgesetzt, solange die aktuell gemessene Eingangsanschlussspannung die Referenzeingangsspannung nicht unterschreitet.

Falls die aktuell gemessene Eingangsanschlussspannung die Referenzeingangsspannung nicht unterschreitet und die ermittelte zweite Zeitdauer eine zweite vorgegebene maximale Zeitdauer überschreitet, wird der zweite Treiberschalter ausgeschaltet und der erste Treiberschalter mit dem fünften vorgegebenen Ansteuerstrom angesteuert, wie dies in Figur 1 schematisch mit einem Übergang 3 in einen Fehlerzustand ST_UCE_FAIL dargestellt ist.

In der zweiten Phase des Einschaltens wird die erste Zeitmessung in der gezeigten Ausführungsform fortgesetzt, falls die aktuell gemessene Steueranschlussspannung die Referenzsteuerspannung wieder unterschreitet. Falls dabei die ermittelte erste Zeitdauer die erste vorgegebene maximale Zeitdauer überschreitet, wird der zweite Treiberschalter ausgeschaltet und der erste Treiberschalter mit dem zweiten vorgegebenen Ansteuerstrom angesteuert, wie dies in Figur 1 schematisch mit einem Übergang 4 dargestellt ist. Es erfolgt somit in diesem Fall ein Übergang von der zweiten Phase ST_PH2_ON des Einschaltens zu der zweiten Phase ST_PH2_OFF des Ausschaltens des Halbleiterschalters.

Falls die aktuell gemessene Eingangsanschlussspannung die Referenzeingangsspannung unterschreitet und die ermittelte zweite Zeitdauer die zweite vorgegebene maximale Zeitdauer nicht überschreitet, erfolgt ein in Figur 1 schematisch dargestellter Übergang 5 von der zweiten Phase ST_PH2_ON des Einschaltens zu der dritten Phase ST_PH3_ON des Einschaltens des Halbleiterschalters. In der dritten Phase ST_PH3_ON des Einschaltens des Halbleiterschalters erfolgt ein Ansteuern des zweiten Treiberschalters mit der zweiten vorgegebenen Ansteuerspannung und ein Beenden der zweiten Zeitmessung. Dabei wird in der dritten Phase ST_PH3_ON des Einschaltens die Eingangsanschlussspannung wiederholt gemessen, gefiltert und mit der Referenzeingangsspannung verglichen. Falls die wiederholt gemessene, gefilterte Eingangsanschlussspannung die Referenzeingangsspannung überschreitet, wird der zweite Treiberschalter ausgeschaltet und der erste Treiberschalter mit dem fünften vorgegebenen Ansteuerstrom angesteuert, wie dies in Figur 1 schematisch mit einem Übergang 6 in den Fehlerzustand ST_UCE_FAIL dargestellt ist.

Der erste Treiberschalter wird dabei mit dem fünften vorgegebenen Ansteuerstrom für eine fünfte vorgegebene Zeitdauer angesteuert. Nach Erreichen der fünften vorgegebenen Zeitdauer wird die Steueranschlussspannung wiederholt gemessen und mit der Referenzsteuerspannung verglichen.

Falls die wiederholt gemessene Steueranschlussspannung die Referenzsteuerspannung nach Erreichen der fünften vorgegebenen Zeitdauer nicht unterschreitet, wird ein Fehlerzustand ST_ERR_OFF erkannt, wie dies in Figur 1 schematisch mit einem Übergang 7 dargestellt ist, und der Steueranschluss wird über einen elektrischen Widerstand mit dem negativen Versorgungsspannungsanschluss gekoppelt beziehungsweise elektrische verbunden. Es wird somit ein redundanter Sicherheitsschalter aktiviert, welcher die Entladung des Steueranschlusses über einen unabhängigen Pfad erzwingen soll. Daraufhin wird der folgende Einschaltimpuls des pulsweiten modulierten Steuersignals ignoriert, um die Wahrscheinlichkeit der Entladung des Steueranschlusses ohne Zerstörung des Halbleiterschalters zu erhöhen. Wird anschließend eine unmittelbar vorausliegende zweite Art der Signalflanke bei dem Steuersignal erkannt, wird der erste Treiberschalter mit der ersten vorgegebenen Ansteuerspannung angesteuert, wie dies in Figur 1 schematisch mit einem Übergang 8 dargestellt ist. Es erfolgt somit ein Übergang zu der dritten Phase ST_PH3_OFF des Ausschaltens des Halbleiterschalters.

Falls die wiederholt gemessene Steueranschlussspannung die Referenzsteuerspannung hingegen nicht überschreitet, wird ein Fehlerzustand ST_PH3_ERR erkannt, wie dies in Figur 1 schematisch mit einem Übergang 9 dargestellt ist. Wird in diesem Fehlerzustand zudem eine unmittelbar vorausliegende zweite Art der Signalflanke bei dem Steuersignal erkannt, wird der erste Treiberschalter mit der ersten vorgegebenen Ansteuerspannung angesteuert, wie dies in Figur 1 schematisch mit einem Übergang 10 dargestellt ist. Es erfolgt somit in diesem Fall ein Übergang von dem Fehlerzustand ST_PH3_ERR zu der dritten Phase ST_PH3_OFF des Ausschaltens des Halbleiterschalters.

In der dritten Phase ST_PH3_ON des Einschaltens wird zudem die erste Zeitmessung fortgesetzt, falls die aktuell gemessene Steueranschlussspannung die Referenzsteuerspannung wieder unterschreitet. Falls dabei die ermittelte erste Zeitdauer die erste vorgegebene maximale Zeitdauer überschreitet, wird der zweite Treiberschalter ausgeschaltet und der erste Treiberschalter mit dem zweiten vorgegebenen Ansteuerstrom angesteuert, wie dies in Figur 1 schematisch mit einem Übergang 11 dargestellt ist. Es erfolgt somit ein Übergang von der dritten Phase ST_PH3_ON des Einschaltens zu der zweiten Phase ST_PH2_OFF des Ausschaltens des Halbleiterschalters.

Bei einer erkannten, unmittelbar vorausliegenden zweiten Art der Signalflanke bei dem Steuersignal erfolgt in der gezeigten Ausführungsform des Verfahrens ein in Figur 1 schematisch dargestellter Übergang 12 von der dritten Phase ST_PH3_ON des Einschaltens zu der ersten Phase ST_PH1_OFF des Ausschaltens des Halbleiterschalters. In der ersten Phase ST_PH1_OFF des Ausschaltens des Halbleiterschalters erfolgt ein Ansteuern des ersten Treiberschalters mit dem ersten vorgegebenen Ansteuerstrom und ein Starten einer dritten Zeitmessung zu Beginn der ersten Phase ST_PH1_OFF des Ausschaltens zur Ermittlung einer dritten Zeitdauer.

Die dritte Zeitmessung wird fortgesetzt, solange die aktuell gemessene Steueranschlussspannung die Referenzsteuerspannung nicht unterschreitet. Falls die ermittelte dritte Zeitdauer eine dritte vorgegebene maximale Zeitdauer überschreitet und die aktuell gemessene Eingangsanschlussspannung die Referenzeingangsspannung nicht überschreitet, wird wiederum der Fehlerzustand ST_ERR_OFF erkannt, wie dies in Figur 1 schematisch mit einem Übergang 13 dargestellt ist, und der Steueranschluss wird über den elektrischen Widerstand mit dem negativen Versorgungsspannungsanschluss gekoppelt. Daraufhin wird der folgende Einschaltimpuls des pulsweiten modulierten Steuersignals ignoriert, um die Wahrscheinlichkeit der Entladung des Steueranschlusses ohne Zerstörung des Halbleiterschalters zu erhöhen. Wird anschließend eine unmittelbar vorausliegende zweite Art der Signalflanke bei dem Steuersignal erkannt, wird der erste Treiberschalter mit der ersten vorgegebenen Ansteuerspannung angesteuert, wie dies in Figur 1 schematisch mit einem Übergang 14 dargestellt ist. Es erfolgt somit in diesem Fall ein Übergang zu der dritten Phase ST_PH3_OFF des Ausschaltens des Halbleiterschalters.

Bei Überschreiten der Referenzeingangsspannung durch die aktuell gemessene Eingangsanschlussspannung erfolgt ein in Figur 1 schematisch dargestellter Übergang 15 von der ersten Phase ST_PH1_OFF des Ausschaltens zu der zweiten Phase ST_PH2_OFF des Ausschaltens des Halbleiterschalters. In der zweiten Phase ST_PH2_OFF des Ausschaltens des Halbleiterschalters erfolgt dabei ein Ansteuern des ersten Treiberschalters mit dem zweiten vorgegebenen Ansteuerstrom und ein Starten einer vierten Zeitmessung zu Beginn der zweiten Phase des Ausschaltens des Halbleiterschalters zur Ermittlung einer vierten Zeitdauer.

Die vierte Zeitmessung wird fortgesetzt, solange die aktuell gemessene Steueranschlussspannung die Referenzsteuerspannung nicht unterschreitet. Falls die aktuell gemessene Steueranschlussspannung die Referenzsteuerspannung nicht unterschreitet und die ermittelte vierte Zeitdauer eine vierte vorgegebene maximale Zeitdauer überschreitet beziehungsweise falls die ermittelte dritte Zeitdauer die dritte vorgegebene maximale Zeitdauer überschreitet und die aktuell gemessene Eingangsanschlussspannung die Referenzeingangsspannung überschreitet, wird wiederum der Fehlerzustand ST_ERR_OFF erkannt, wie dies in Figur 1 schematisch mit einem Übergang 16 dargestellt ist, und der Steueranschluss wird über den elektrischen Widerstand mit dem negativen Versorgungsspannungsanschluss gekoppelt. Daraufhin wird der folgende Einschaltimpuls des pulsweiten modulierten Steuersignals ignoriert, um die Wahrscheinlichkeit der Entladung des Steueranschlusses ohne Zerstörung des Halbleiterschalters zu erhöhen. Wird anschließend eine unmittelbar vorausliegende zweite Art der Signalflanke bei dem Steuersignal erkannt, wird der erste Treiberschalter mit der ersten vorgegebenen Ansteuerspannung angesteuert, wie dies in Figur 1 schematisch mit dem Übergang 14 dargestellt ist. Es erfolgt somit in diesem Fall ein Übergang zu der dritten Phase ST_PH3_OFF des Ausschaltens des Halbleiterschalters.

Falls hingegen die aktuell gemessene Steueranschlussspannung die Referenzsteuerspannung unterschreitet und dabei die ermittelte dritte Zeitdauer die dritte vorgegebene maximale Zeitdauer nicht überschreitet sowie die ermittelte vierte Zeitdauer die vierte vorgegebene maximale Zeitdauer nicht überschreitet, erfolgt ein in Figur 1 schematisch dargestellter Übergang 17 von der zweiten Phase ST_PH2_OFF des Ausschaltens zu der dritten Phase ST_PH3_OFF des Ausschaltens des Halbleiterschalters. In der dritten Phase ST_PH3_OFF des Ausschaltens des Halbleiterschalters erfolgt dabei ein Ansteuern des ersten Treiberschalters mit der ersten vorgegebenen Ansteuerspannung.

Bei einer erkannten, unmittelbar vorausliegenden ersten Art der Signalflanke bei dem Steuersignal erfolgt in der gezeigten Ausführungsform des Verfahrens ein in Figur 1 schematisch dargestellter Übergang 18 von der dritten Phase ST_PH3_OFF des Ausschaltens zu der ersten Phase ST_PH1_ON des Einschaltens des Halbleiterschalters.

In der gezeigten Ausführungsform wird der vorgesehene, fehlerfreie Schaltverlauf somit durch jeweils drei Lade- und Entladephasen gebildet. Die Zustandübergänge werden dabei im Normalbetrieb ausschließlich durch Schaltflanken eines pulsweiten modulierten Steuersignals sowie Signalen von Vergleichseinheiten, beispielsweise in Form von Gate- und Kollektorkomparatorsignalen ausgelöst, wie im Folgenden weiter erläutert wird. Um eine hohe Fehlerrobustheit zu erreichen, werden in der gezeigten Ausführungsform komplexe Überwachungs- und Fehlerreaktionsmechanismen definiert, die je nach Fehlerfall in den direkten Schaltpfad eingreifen oder über einen zusätzlichen Sicherheitspfad die Abschaltung des Halbleiterschalters anfordern.

Mittels konfigurierbarer Timer werden die Schaltphasen zeitlich überwacht. Bei Überschreitung einer jeweiligen Timerschwelle wird in Abhängigkeit vom aktuellen Schaltzustand eine kontrollierte Abschaltung des Halbleiterschalters eingeleitet. Ist diese ebenfalls zeitlich überwachte Abschaltung nicht zielführend, wird ein redundanter Sicherheitsschalter aktiviert, welcher die Entladung des Steueranschlusses über einen unabhängigen Pfad erzwingen soll.

Das gezeigte Verfahren ermöglicht somit eine höhere Fehlerrobustheit und Zuverlässigkeit. Die Überwachung des Schaltverhaltens sowie die Fehlerbehandlung erhöht die Zuverlässigkeit des Systems durch eine Reduzierung der Ausfallwahrscheinlichkeit des Halbleiterschalters. Ferner können Sicherheitsanforderungen für sicherheitsrelevante elektrische beziehungsweise elektronische Systeme insbesondere in Fahrzeug-Applikationen erfüllt werden. Zudem werden erweiterte Diagnosemöglichkeiten bereitgestellt. Dabei erleichtern detailiierte Informationen über die Ursachen der dedektierten Fehler die Fehlerbehebung sowie die Entwicklung fehlerrobuster Systeme.

In der gezeigten Ausführungsform ist der Halbleiterschalter, wie bereits erläutert, ein n-Kanal IGBT oder ein n-Kanal MOSFET. Das Verfahren kann jedoch in analoger Weise für einen p-Kanal IGBT oder einen p-Kanal MOSFET angewendet werden, wobei insbesondere der Wert der Referenzsteuerspannung entsprechend angepasst wird.

Figur 2 zeigt eine Antriebsvorrichtung AV zum Antrieb eines in Figur 2 nicht näher dargestellten Elektro- oder Hybridfahrzeugs mit einer elektrischen Maschine EM und einem Stromrichter SR in einer schematischen Darstellung gemäß einer Ausführungsform.

Die elektrische Maschine EM ist mit einer in Figur 2 nicht näher dargestellten Antriebswelle des Fahrzeugs zur Drehmomentübertragung mechanisch gekoppelt und dient zum Vortrieb des Fahrzeugs.

Der Stromrichter SR dient zum Bereitstellen von Phasenströmen Ip für die elektrische Maschine EM und weist eine Dreifach-Halbbrückenschaltung DHS mit jeweils einem hochvoltseitigen (auf Englisch "High-Side") und einem niedervoltseitigen (auf Englisch "Low-Side") Halbleiterschalter HS1 und HS2, HS3 und HS4 beziehungsweise HS5 und HS6 in einer Reihenschaltung auf. Jeder der sechs Halbleiterschalter HS1 bis HS6 weist jeweils einen Eingangsstromanschluss EHS, einen Ausgangsstromanschluss AHS und zwischen dem Eingangsstromanschluss EHS und dem Ausgangsstromanschluss AHS eine Laststrecke zum Durchleiten eines Laststromes von dem Eingangsstromanschluss EHS zu dem Ausgangsstromanschluss AHS und anschließend zu der elektrischen Maschine EM als Phasenstrom Ip auf. Ferner weisen die Halbleiterschalter HS1 bis HS6 jeweils einen Steueranschluss SHS auf, über den der jeweilige Halbleiterschalter HS1 bis HS6 angesteuert wird, um im eingeschalteten Zustand des jeweiligen Halbleiterschalters den Durchfluss des Laststroms durch die Laststrecke zu ermöglichen beziehungsweise im ausgeschalteten Zustand des jeweiligen Halbleiterschalters den Durchfluss des Laststroms durch die Laststrecke zu sperren. Die Halbleiterschalter HS1 bis HS6 sind in der gezeigten Ausführungsform n-Kanal IGBTs.

Zu jedem dieser sechs Halbleiterschalter HS1 bis HS6 weist der Stromrichter SR jeweils eine Schaltungsanordnung SA1, SA2, SA3, SA4, SA5 beziehungsweise SA6 zur Steuerung des jeweiligen Halbleiterschalters HS1 bis HS6 auf, wobei die sechs Schaltungsanordnungen SA1 bis SA6 zueinander funktional weitgehend identisch ausgebildet sind. Zur Vereinfachung der Beschreibung der Antriebsvorrichtung AV wird lediglich eine der sechs Schaltungsanordnungen SA1 bis SA6 nachfolgend detailliert beschrieben.

So wie die restlichen fünf Schaltungsanordnungen SA2 bis SA6 weist die erste Schaltungsanordnung SA1 eine Treiberschaltungseinheit in Form einer Halbbrückenschaltungseinheit HB, eine erste Vergleichseinheit VE1, eine zweite Vergleichseinheit VE2, eine Speichereinheit SE sowie eine Ansteuereinheit AE auf. Die Schaltungsanordnung SA1 ist mit Ausnahme von der Halbbrückenschaltungseinheit HB in einem ASIC-Bauteil ausgebildet. Dies ermöglicht eine erhebliche Reduktion der Bauteilanzahl und Bauteilkosten, benötigt weniger Leiterplattenplatz und führt zu geringeren Produktionskosten, insbesondere bei Lagerhaltung, Bestückung und Testen der Komponenten. Zudem sind zusätzliche Funktionalitäten integrierbar. Ferner sind dadurch höhere Schaltgeschwindigkeiten einstellbar, eine höhere Zuverlässigkeit sowie eine erhöhte Robustheit gegenüber EMV-Störungen werden ermöglicht und die Diagnosemöglichkeiten erweitert.

Die Halbbrückenschaltungseinheit HB weist ihrerseits je einen ersten, zwischen dem Steueranschluss SHS des Halbleiterschalters HS1 und einem ersten, negativen Versorgungsspannungsanschluss NA angeordneten, steuerbaren Treiberschalter T1 und einen zweiten, zwischen dem Steueranschluss SHS des Halbleiterschalters HS1 und einem zweiten, positiven Versorgungsspannungsanschluss HA angeordneten, steuerbaren Treiberschalter T2 in einer Reihenschaltung auf, wobei der Knotenpunkt zwischen den beiden Treiberschaltern T1 und T2, der diese beiden Treiberschalter T1 und T2 verbindet, mit dem Steueranschluss SHS des Halbleiterschalters HS1 der Dreifach-Halbbrückenschaltung DHS elektrisch verbunden ist. Dadurch wird der Halbleiterschalter HS1 der Dreifach-Halbbrückenschaltung DHS von dieser Halbbrückenschaltungseinheit HB gesteuert geschalten. Die Treiberschalter T1 und T2 sind in der gezeigten Ausführungsform Halbleiterschalter in Form von MOSFETs.

Die erste Vergleichseinheit VE1 weist einen ersten und einen zweiten Eingangsanschluss E11, E12 und einen Ausgangsanschluss A11 auf und ist über den ersten Eingangsanschluss E11 mit dem Eingangsstromanschluss EHS des Halbleiterschalters HS1 elektrisch verbunden. Über diesen ersten Eingangsanschluss E11 misst die erste Vergleichseinheit VE1 das Spannungspotential UE an dem Eingangsstromanschluss EHS des Halbleiterschalters HS1. Über den zweiten Eingangsanschluss E12 erhält die erste Vergleichseinheit VE1 ein erstes Referenzspannungspotential UE_TH von einer nicht näher dargestellten Einheit. Die erste Vergleichseinheit VE1 vergleicht das gemessene Spannungspotential UE mit dem Referenzspannungspotential UE_TH und gibt abhängig von dem Vergleichsergebnis ein Ausgangssignal an dem Ausgangsanschluss A11 aus, welches an eine Ansteuereinheit AE der Schaltungsanordnung SA1 übermittelt wird.

Die zweite Vergleichseinheit VE2 weist einen ersten und einen zweiten Eingangsanschluss E21, E22 und einen Ausgangsanschluss A21 auf und ist über den ersten Eingangsanschluss E21 mit dem Steueranschluss SHS des Halbleiterschalters HS1 elektrisch verbunden. Über diesen ersten Eingangsanschluss E21 misst die zweite Vergleichseinheit VE2 das Spannungspotential US an dem Steueranschluss SHS des Halbleiterschalters HS1. Über den zweiten Eingangsanschluss E22 erhält die zweite Vergleichseinheit VE2 ein zweites Referenzspannungspotential US_TH von einer nicht näher dargestellten Einheit. Die zweite Vergleichseinheit VE2 vergleicht das gemessene Spannungspotential US mit dem Referenzspannungspotential US_TH und gibt abhängig von dem Vergleichsergebnis ein Ausgangssignal an dem Ausgangsanschluss A21 aus, welches an die Ansteuereinheit AE der Schaltungsanordnung SA1 übermittelt wird.

Die erste Vergleichseinheit VE1 und die zweite Vergleichseinheit VE2 sind typischerweise jeweils als Komparator ausgebildet.

Die Ansteuereinheit AE ist zum Ansteuern des Halbleiterschalters HS1 durch gesteuertes, phasenweises Ein- und Ausschalten der beiden Treiberschalter T1 und T2 unter Verwendung eines pulsweiten modulierten Steuersignals PWM, das von einer nicht näher dargestellten zentralen Ansteuereinheit bereitgestellt wird, und insbesondere unter Verwendung von steigenden Signalflanken SSF und fallenden Signalflanken FSF des pulsweiten modulierten Steuersignals PWM ausgebildet. Dazu wird der Steueranschluss SHS des Halbleiterschalters HS1 mit dem ersten vorgegebenen Ansteuerstrom IAS1, dem zweiten vorgegebenen Ansteuerstrom IAS2 beziehungsweise dem fünften vorgegebenen Ansteuerstrom IAS5 entladen und mit dem dritten vorgegebenen Ansteuerstrom IAS3 beziehungsweise dem vierten vorgegebenen Ansteuerstrom IAS4 geladen. Zudem kann der Steueranschluss SHS über den Treiberschalter T2 fest auf die Spannung des zweiten, positiven Versorgungsspannungsanschlusses HA beziehungsweise über den Treiberschalter T1 fest auf die Spannung des ersten, negativen Versorgungsspannungsanschlusses NA geschaltet werden. Die an dem zweiten, positiven Versorgungsspannungsanschluss HA anliegende Spannung entspricht damit in diesem Fall der zweiten vorgegebenen Ansteuerspannung und die an dem ersten, negativen Versorgungsspannungsanschluss NA anliegende Spannung der ersten vorgegebenen Ansteuerspannung.

Ferner weist die Schaltungsanordnung SA1 eine Zeitmesseinheit ZME, beispielsweise in Form eines Taktgenerators beziehungsweise Oszillators, zum Starten einer Zeitmessung zu Beginn der ersten und der zweiten Phase des phasenweisen Einschaltens und zu Beginn der ersten und der zweiten Phase des phasenweisen Ausschaltens des Halbleiterschalters HS1 zur Ermittlung entsprechender Zeitdauern auf, wobei die Zeitmessungen wie im Zusammenhang mit Figur 1 beschrieben erfolgen. Darüber hinaus weist die Schaltungsanordnung SA1 eine dritte Vergleichseinheit VE3 zum Vergleichen der ermittelten Zeitdauern mit jeweiligen vorgegebenen maximalen Zeitdauern auf, wie ebenfalls im Zusammenhang mit Figur 1 näher beschrieben wurde. Die Ansteuereinheit AE ist derart zum Ansteuern des Halbleiterschalters HS1 mittels der beiden Treiberschalter T1 und T2 ausgebildet, dass der Halbleiterschalter HS1 jeweils in einen vorgegebenen Betriebszustand geschaltet wird, falls die entsprechende ermittelte Zeitdauer die dazugehörige vorgegebene maximale Zeitdauer überschreitet, wie im Zusammenhang mit Figur 1 erläutert. Zudem kann der Steueranschluss SHS bei dem in Figur 1 beschriebenen Fehlerzustand ST_ERR_OFF durch Schließen eines Schalters S über einen elektrischen Widerstand R1 mit dem negativen Versorgungsspannungsanschluss NA gekoppelt werden.

Die genannten Ansteuerströme IAS1 bis IAS5 sowie die vorgegebenen maximalen Zeitdauern sind in der gezeigten Ausführungsform in einer Speichereinheit SE der Schaltungsanordnung SA1 abgelegt.

Als Basis für die Ansteuerung und Überwachung der Schaltphasen dient dabei ein zweigeteiltes Konzept, welches als digitale Logik implementiert ist.

Ein direkter Pfad ermöglicht die schnellstmögliche Umsetzung der PWM-Schaltbefehle der nicht näher dargestellten zentralen Ansteuereinheit und Reaktion auf die beispielsweise Gate- und Kollektorkomparatorsignale des Halbleiterschalters HS1. Durch die Implementierung mittels rein kombinatorischer Logik wird zudem ein jitterfreies Schaltverhalten erreicht und annähernd deckungsgleiche Schaltzyklen generiert. Dies ermöglicht eine schnelle und verlustarme Halbleiterschalteransteuerung. Über einen Parallelpfad werden die Eingangssignale taktsynchronisiert und deren zeitlich korrekte Abfolge beispielsweise durch einen getakteten Zustandsautomaten und gekoppelte Timermodule überwacht.

Die nicht näher dargestellte zentrale Ansteuereinheit erkennt anhand der Status-Rückmeldung den Fehlerfall und leitet auf Systemeben die entsprechende Reaktion ein. Der Zustandsautomat überwacht die korrekte Fehlerbehandlung und ermöglicht daraufhin ein erneutes Einschalten des Halbleiterschalters HS1. Über eine nicht näher dargestellte Diagnose-Leitung können zudem genaue Informationen über das jeweilige Fehlerbild zurückgemeldet werden. Diese Diagnoseinformationen erleichtern die Fehlerbehebung sowie die Entwicklung eines fehlerrobusten Systems.

Zudem kann eine Rückmeldung des jeweiligen Kollektorkomparatorzustands über eine nicht näher dargestellte Status-Leitung erfolgen, welche von der zentralen Ansteuereinheit überwacht wird.

## Patentansprüche

1. Verfahren zum Ansteuern eines steuerbaren Halbleiterschalters (HS1) mit einem Steuersignal durch gesteuertes, phasenweises Ein- und Ausschalten, wobei das Verfahren folgende Verfahrensschritte aufweist:
- Starten einer Zeitmessung (ST_PH1_ON) zu Beginn zumindest einer Phase des phasenweisen Ein- und Ausschaltens zur Ermittlung einer Zeitdauer (ST_PH2_ON), wobei die Zeitmessung solange fortgesetzt wird, bis eine auf die zumindest eine Phase folgende Phase des phasenweisen Ein- und Ausschaltens beginnt,
- Vergleichen der ermittelten Zeitdauer mit einer vorgegebenen maximalen Zeitdauer (ST_PH3_ON),
- falls die ermittelte Zeitdauer die vorgegebene maximale Zeitdauer überschreitet (ST_ERR_OFF), Ansteuern des Halbleiterschalters (HS1) derart, dass der Halbleiterschalter (HS1) in einen ausgeschalteten Betriebszustand geschaltet wird (ST_OCE_fAlL).

2. Verfahren nach Anspruch 1, wobei der Halbleiterschalter (HS1) einen Steueranschluss (SHS), einen Eingangsstromanschluss (EHS) sowie einen Ausgangsstromanschluss (AHS) aufweist und über den Steueranschluss (SHS) steuerbar ist und wobei das Steuersignal ein pulsweiten moduliertes Steuersignal (PWM) ist und wobei das Ansteuern des Halbleiterschalters (HS1) zudem mittels einer Treiberschaltungseinheit erfolgt, wobei die Treiberschaltungseinheit einen ersten, zwischen dem Steueranschluss (SHS) des Halbleiterschalters (HS1) und einem ersten, negativen Versorgungsspannungsanschluss (NA) angeordneten, steuerbaren Treiberschalter (T1) und einen zweiten, zwischen dem Steueranschluss (SHS) des Halbleiterschalters (HS1) und einem zweiten, positiven Versorgungsspannungsanschluss (HA) angeordneten, steuerbaren Treiberschalter (T2) aufweist und das Ansteuern des Halbleiterschalters (HS1) durch gesteuertes, phasenweises Ein- und Ausschalten des ersten Treiberschalters (T1) und des zweiten Treiberschalter (T2) erfolgt und wobei das Verfahren zudem folgende Verfahrensschritte aufweist:
- Erkennen einer ersten Art oder einer zweiten, von der ersten Art verschiedenen Art einer Signalflanke bei dem Steuersignal (PWM),
- Messen einer Eingangsanschlussspannung (UE) an dem Eingangsstromanschluss (EHS) des Halbleiterschalters (HS1),
- Vergleichen der gemessenen Eingangsanschlussspannung (UE) mit einer Referenzeingangsspannung (UE_TH),
- Messen einer Steueranschlussspannung (US) an dem Steueranschluss (SHS) des Halbleiterschalters (HS1),
- Vergleichen der gemessenen Steueranschlussspannung (US) mit einer Referenzsteuerspannung (US_TH),
- wobei das Ansteuern des Halbleiterschalters (HS1) durch gesteuertes, phasenweises Ein- und Ausschalten des ersten (T1) und des zweiten (T2) Treiberschalters abhängig
• von der erkannten, unmittelbar vorausliegenden ersten Art oder zweiten Art der Signalflanke bei dem Steuersignal (PWM) und/oder
• von dem Vergleichsergebnis zwischen der aktuell gemessenen Eingangsanschlussspannung (UE) und der Referenzeingangsspannung (UE_TH) und/oder
• von dem Vergleichsergebnis zwischen der aktuell gemessenen Steueranschlussspannung (US) und der Referenzsteuerspannung (US_TH),
erfolgt.

3. Verfahren nach Anspruch 2, wobei das Ansteuern des Halbleiterschalters (HS1) durch gesteuertes, phasenweises Ein- und Ausschalten des ersten (T1) und des zweiten (T2) Treiberschalters wahlweise mit einer ersten vorgegebenen Ansteuerspannung, einer zweiten vorgegebenen Ansteuerspannung, einem ersten vorgegebenen Ansteuerstrom (IAS1), einem zweiten, von dem ersten vorgegebenen Ansteuerstrom (IAS1) unabhängigen vorgegebenen Ansteuerstrom (IAS2), einem dritten vorgegebenen Ansteuerstrom (IAS3), einem vierten, von dem dritten vorgegebenen Ansteuerstrom (IAS3) unabhängigen vorgegebenen Ansteuerstrom (IAS4) oder einem fünften, dem ersten vorgegebenen Ansteuerstrom (IAS1) und dem zweiten vorgegebenen Ansteuerstrom (IAS2) gegenüber niedrigeren vorgegebenen Ansteuerstrom (IAS5) erfolgt.

4. Verfahren nach Anspruch 2 oder Anspruch 3, wobei in einer ersten Phase eines Einschaltens des Halbleiterschalters (HS1) ein Ansteuern des zweiten Treiberschalters (T2) mit dem dritten vorgegebenen Ansteuerstrom (IAS3) und ein Starten einer ersten Zeitmessung zu Beginn der ersten Phase des Einschaltens zur Ermittlung einer ersten Zeitdauer bei einer erkannten, unmittelbar vorausliegenden ersten Art der Signalflanke bei dem Steuersignal (PWM) erfolgt und wobei die erste Zeitmessung fortgesetzt wird, solange die aktuell gemessene Steueranschlussspannung (US) die Referenzsteuerspannung (US_TH) nicht überschreitet und wobei, falls die ermittelte erste Zeitdauer eine erste vorgegebene maximale Zeitdauer überschreitet, der zweite Treiberschalter (T2) ausgeschaltet wird und der erste Treiberschalter (T1) mit dem zweiten vorgegebenen Ansteuerstrom (IAS2) angesteuert wird.

5. Verfahren nach Anspruch 4, wobei in einer zweiten Phase des Einschaltens des Halbleiterschalters (HS1) ein Ansteuern des zweiten Treiberschalters (T2) mit dem vierten Ansteuerstrom (IAS4) und ein Starten einer zweiten Zeitmessung zu Beginn der zweiten Phase des Einschaltens zur Ermittlung einer zweiten Zeitdauer bei Überschreiten der Referenzsteuerspannung (US_TH) durch die aktuell gemessene Steueranschlussspannung (US) erfolgt und wobei die zweite Zeitmessung fortgesetzt wird, solange die aktuell gemessene Eingangsanschlussspannung (UE) die Referenzeingangsspannung (UE_TH) nicht unterschreitet und wobei, falls die ermittelte zweite Zeitdauer eine zweite vorgegebene maximale Zeitdauer überschreitet, der zweite Treiberschalter (T2) ausgeschaltet wird und der erste Treiberschalter (T1) mit dem fünften vorgegebenen Ansteuerstrom (IAS5) angesteuert wird.

6. Verfahren nach Anspruch 5, wobei in der zweiten Phase des Einschaltens die erste Zeitmessung fortgesetzt wird, falls die aktuell gemessene Steueranschlussspannung (US) die Referenzsteuerspannung (US_TH) wieder unterschreitet, und wobei, falls die ermittelte erste Zeitdauer die erste vorgegebene maximale Zeitdauer überschreitet, der zweite Treiberschalter (T2) ausgeschaltet wird und der erste Treiberschalter (T1) mit dem zweiten vorgegebenen Ansteuerstrom (IAS2) angesteuert wird.

7. Verfahren nach Anspruch 5 oder Anspruch 6, wobei in einer dritten Phase des Einschaltens des Halbleiterschalters (HS1) ein Ansteuern des zweiten Treiberschalters (T2) mit der zweiten vorgegebenen Ansteuerspannung bei Unterschreiten der Referenzeingangsspannung (UE_TH) durch die aktuell gemessene Eingangsanschlussspannung (UE) erfolgt und wobei in der dritten Phase des Einschaltens die Eingangsanschlussspannung (UE) wiederholt gemessen und mit der Referenzeingangsspannung (UE_TH) verglichen wird und wobei, falls die wiederholt gemessene Eingangsanschlussspannung (UE) die Referenzeingangsspannung (UE_TH) überschreitet, der zweite Treiberschalter (T2) ausgeschaltet wird und der erste Treiberschalter (T1) mit dem fünften vorgegebenen Ansteuerstrom (IAS5) angesteuert wird.

8. Verfahren nach Anspruch 7, wobei in der dritten Phase des Einschaltens die erste Zeitmessung fortgesetzt wird, falls die aktuell gemessene Steueranschlussspannung (US) die Referenzsteuerspannung (US_TH) wieder unterschreitet, und wobei, falls die ermittelte erste Zeitdauer die erste vorgegebene maximale Zeitdauer überschreitet, der zweite Treiberschalter (T2) ausgeschaltet wird und der erste Treiberschalter (T1) mit dem zweiten vorgegebenen Ansteuerstrom (IAS2) angesteuert wird.

9. Verfahren nach Anspruch 5 oder Anspruch 7, wobei der erste Treiberschalter (T1) mit dem fünften vorgegebenen Ansteuerstrom (IAS5) für eine fünfte vorgegebene Zeitdauer angesteuert wird und wobei nach Erreichen der fünften vorgegebenen Zeitdauer die Steueranschlussspannung (US) wiederholt gemessen und mit der Referenzsteuerspannung (US_TH) verglichen wird.

10. Verfahren nach Anspruch 9, wobei der Steueranschluss (SHS) über einen elektrischen Widerstand (R1) mit dem negativen Versorgungsspannungsanschluss (NA) gekoppelt wird, falls die wiederholt gemessene Steueranschlussspannung (US) die Referenzsteuerspannung (US_TH) nach Erreichen der fünften vorgegebenen Zeitdauer nicht unterschreitet, und wobei der erste Treiberschalter (T1) mit der ersten vorgegebenen Ansteuerspannung angesteuert wird, falls die wiederholt gemessene Steueranschlussspannung (US) die Referenzsteuerspannung (US_TH) nicht überschreitet und zudem eine unmittelbar vorausliegende zweite Art der Signalflanke bei dem Steuersignal (PWM) erkannt wird.

11. Verfahren nach einem der Ansprüche 2 bis 10, wobei in einer ersten Phase des Ausschaltens des Halbleiterschalters (HS1) ein Ansteuern des ersten Treiberschalters (T1) mit dem ersten vorgegebenen Ansteuerstrom (IAS1) und ein Starten einer dritten Zeitmessung zu Beginn der ersten Phase des Ausschaltens zur Ermittlung einer dritten Zeitdauer bei einer erkannten, unmittelbar vorausliegenden zweiten Art der Signalflanke bei dem Steuersignal (PWM) erfolgt und wobei die dritte Zeitmessung fortgesetzt wird, solange die aktuell gemessene Steueranschlussspannung (US) die Referenzsteuerspannung (US_TH) nicht unterschreitet und wobei, falls die ermittelte dritte Zeitdauer eine dritte vorgegebene maximale Zeitdauer überschreitet, der Steueranschluss (SHS) über einen elektrischen Widerstand (R1) mit dem negativen Versorgungsspannungsanschluss (NA) gekoppelt wird.

12. Verfahren nach Anspruch 11, wobei in einer zweiten Phase des Ausschaltens des Halbleiterschalters (HS1) ein Ansteuern des ersten Treiberschalters (T1) mit dem zweiten vorgegebenen Ansteuerstrom (IAS2) und ein Starten einer vierten Zeitmessung zu Beginn der zweiten Phase des Ausschaltens des Halbleiterschalters (HS1) zur Ermittlung einer vierten Zeitdauer bei Überschreiten der Referenzeingangsspannung (UE_TH) durch die aktuell gemessene Eingangsanschlussspannung (UE) erfolgt und wobei die vierte Zeitmessung fortgesetzt wird, solange die aktuell gemessene Steueranschlussspannung (US) die Referenzsteuerspannung (US_TH) nicht unterschreitet und wobei, falls die ermittelte vierte Zeitdauer eine vierte vorgegebene maximale Zeitdauer überschreitet, der Steueranschluss (SHS) über einen elektrischen Widerstand (R1) mit dem negativen Versorgungsspannungsanschluss (NA) gekoppelt wird.

13. Verfahren nach Anspruch 12, wobei in einer dritten Phase des Ausschaltens des Halbleiterschalters (HS1) ein Ansteuern des ersten Treiberschalters (T1) mit der ersten vorgegebenen Ansteuerspannung bei Unterschreiten der Referenzsteuerspannung (US_TH) durch die aktuell gemessene Steueranschlussspannung (US) erfolgt.

14. Schaltungsanordnung (SA1) zum Ansteuern eines steuerbaren Halbleiterschalters (HS1) mit einem Steuersignal, wobei die Schaltungsanordnung (SA1) folgende Merkmale aufweist:
- eine Ansteuereinheit (AE) zum Ansteuern des Halbleiterschalters (HS1) durch gesteuertes, phasenweises Ein- und Ausschalten,
- eine Zeitmesseinheit (ZME) zum Starten einer Zeitmessung zu Beginn zumindest einer Phase des phasenweisen Ein- und Ausschaltens zur Ermittlung einer Zeitdauer, wobei die Zeitmessung solange fortgesetzt wird, bis eine auf die zumindest eine Phase folgende Phase des phasenweisen Ein- und Ausschaltens beginnt,
- eine Vergleichseinheit (VE3) zum Vergleichen der ermittelten Zeitdauer mit einer vorgegebenen maximalen Zeitdauer,
wobei die Ansteuereinheit (AE) derart zum Ansteuern des Halbleiterschalters (HS1) ausgebildet ist, dass der Halbleiterschalter (HS1) in einen ausgeschalteten Betriebszustand geschaltet wird, falls die ermittelte Zeitdauer die vorgegebene maximale Zeitdauer überschreitet.

15. Schaltungsanordnung (SA1) nach Anspruch 14, wobei der Halbleiterschalter (HS1) einen Steueranschluss (SHS), einen Eingangsstromanschluss (EHS) sowie einen Ausgangsstromanschluss (AHS) aufweist und über den Steueranschluss (SHS) steuerbar ist und wobei das Steuersignal ein pulsweiten moduliertes Steuersignal (PWM) ist und wobei die Schaltungsanordnung (SA1) zudem folgende Merkmale aufweist:
- eine zumindest einen steuerbaren Treiberschalter aufweisende Treiberschaltungseinheit,
- eine erste Vergleichseinheit (VE1) zum Messen einer Eingangsanschlussspannung (UE) an dem Eingangsstromanschluss (EHS) des Halbleiterschalters (HS1) und zum Vergleichen der gemessenen Eingangsanschlussspannung (UE) mit einer Referenzeingangsspannung (UE_TH),
- eine zweite Vergleichseinheit (VE2) zum Messen einer Steueranschlussspannung (US) an dem Steueranschluss (SHS) des Halbleiterschalters (HS1) und zum Vergleichen der gemessenen Steueranschlussspannung (US) mit einer Referenzsteuerspannung (US_TH)
und wobei die Ansteuereinheit (AE) zum Ansteuern des Halbleiterschalters (HS1) durch gesteuertes, phasenweises Ein- und Ausschalten des zumindest einen Treiberschalters ausgebildet ist.

## Claims

1. Method for actuating a controllable semiconductor switch (HS1) using a control signal by controlled, phase-based switching-on and switching-off, wherein the method comprises the following method steps:
- starting a time measurement (ST_PH1_ON) at the beginning of at least one phase of the phase-based switching-on and switching off in order to determine a duration (ST_PH2_ON), wherein the time measurement is continued until a phase following the at least one phase of the phase-based switching-on and switching off begins,
- comparing the determined duration with a preset maximum duration (ST_PH3_ON),
- if the determined duration exceeds (ST_ERR_OFF) the preset maximum duration, actuating the semiconductor switch (HS1) in such a way that the semiconductor switch (HS1) is switched into a switched-off operating state (ST_UCE_FAIL).

2. Method according to Claim 1, wherein the semiconductor switch (HS1) has a control connection (SHS), an input current connection (EHS) and an output current connection (AHS) and is controllable via the control connection (SHS), and wherein the control signal is a pulse-width-modulated control signal (PWM), and wherein the actuation of the semiconductor switch (HS1) additionally takes place by means of a driver circuit unit, wherein the driver circuit unit has a first controllable driver switch (T1), which is arranged between the control connection (SHS) of the semiconductor switch (HS1) and a first, negative supply voltage connection (NA), and a second controllable driver switch (T2), which is arranged between the control connection (SHS) of the semiconductor switch (HS1) and a second, positive supply voltage connection (HA), and the actuation of the semiconductor switch (HS1) takes place by controlled, phase-based switching-on and switching-off of the first driver switch (T1) and the second driver switch (T2), and wherein the method additionally comprises the following method steps:
- identifying a first type or a second type, which is different than the first type, of signal edge in the control signal (PWM),
- measuring an input connection voltage (UE) at the input current connection (EHS) of the semiconductor switch (HS1),
- comparing the measured input connection voltage (UE) with a reference input voltage (UE_TH),
- measuring a control connection voltage (US) at the control connection (SHS) of the semiconductor switch (HS1),
- comparing the measured control connection voltage (US) with a reference control voltage (US_TH),
- wherein the actuation of the semiconductor switch (HS1) takes place by controlled, phase-based switching-on and switching-off of the first driver switch (T1) and the second driver switch (T2) depending
• on the identified, directly preceding first type or second type of signal edge in the control signal (PWM) and/or
• on the comparison result between the presently measured input connection voltage (UE) and the reference input voltage (UE_TH) and/or
• on the comparison result between the presently measured control connection voltage (US) and the reference control voltage (US_TH).

3. Method according to Claim 2, wherein the actuation of the semiconductor switch (HS1) takes place by controlled, phase-based switching-on and switching-off of the first driver switch (T1) and the second driver switch (T2) optionally with a first preset actuation voltage, a second preset actuation voltage, a first preset actuation current (IAS1), a second preset actuation current (IAS2), which is independent of the first preset actuation current (IAS1), a third preset actuation current (IAS3), a fourth preset actuation current (IAS4), which is independent of the third preset actuation current (IAS3), or a fifth preset actuation current (IAS5), which is lower than the first preset actuation current (IAS1) and the second preset actuation current (IAS2).

4. Method according to Claim 2 or Claim 3, wherein, in a first phase of switching-on of the semiconductor switch (HS1), actuation of the second driver switch (T2) with the third preset actuation current (IAS3) and starting of a first time measurement at the beginning of the first phase of switching-on in order to determine a first duration in the case of an identified, directly preceding first type of signal edge in the control signal (PWM) takes place, and wherein the first time measurement is continued as long as the presently measured control connection voltage (US) does not exceed the reference control voltage (US_TH), and wherein, if the determined first duration exceeds a first preset maximum duration, the second driver switch (T2) is switched off and the first driver switch (T1) is actuated by the second preset actuation current (IAS2).

5. Method according to Claim 4, wherein, in a second phase of switching-on of the semiconductor switch (HS1), actuation of the second driver switch (T2) by the fourth actuation current (IAS4) and starting of a second time measurement at the beginning of the second phase of switching-on in order to determine a second duration in the event of the reference control voltage (US_TH) being exceeded by the presently measured control connection voltage (US) takes place, and wherein the second time measurement is continued as long as the presently measured input connection voltage (UE) does not fall below the reference input voltage (US_TH), and wherein, if the determined second duration exceeds a second preset maximum duration, the second driver switch (T2) is switched off and the first driver switch (T1) is actuated by the fifth preset actuation current (IAS5).

6. Method according to Claim 5, wherein, in the second phase of switching-on, the first time measurement is continued if the presently measured control connection voltage (US) falls below the reference control voltage (US_TH) again, and wherein, if the determined first duration exceeds the first preset maximum duration, the second driver switch (T2) is switched off and the first driver switch (T1) is actuated by the second preset actuation current (IAS2).

7. Method according to Claim 5 or Claim 6, wherein, in a third phase of switching-on of the semiconductor switch (HS1), actuation of the second driver switch (T2) by the second preset actuation voltage takes place in the event that the presently measured input connection voltage (UE) falls below the reference input voltage (UE TH), and wherein, in the third phase of switching-on, the input connection voltage (UE) is measured repeatedly and compared with the reference input voltage (UE_TH), and wherein, if the repeatedly measured input connection voltage (UE) exceeds the reference input voltage (UE_TH), the second driver switch (T2) is switched off and the first driver switch (T1) is actuated by the fifth preset actuation current (IAS5).

8. Method according to Claim 7, wherein, in the third phase of switching-on, the first time measurement is continued if the presently measured control connection voltage (US) falls below the reference control voltage (US TH) again, and wherein, if the determined first duration exceeds the first preset maximum duration, the second driver switch (T2) is switched off and the first driver switch (T1) is actuated by the second preset actuation current (IAS2).

9. Method according to Claim 5 or Claim 7, wherein the first driver switch (T1) is actuated by the fifth preset actuation current (IAS5) for a fifth preset duration, and wherein, once the fifth preset duration has been reached, the control connection voltage (US) is measured repeatedly and compared with the reference control voltage (US_TH).

10. Method according to Claim 9, wherein the control connection (SHS) is coupled to the negative supply voltage connection (NA) via an electrical resistor (R1) if the repeatedly measured control connection voltage (US) does not fall below the reference control voltage (US_TH) once the fifth preset duration has been reached, and wherein the first driver switch (T1) is actuated by the first preset actuation voltage if the repeatedly measured control connection voltage (US) does not exceed the reference control voltage (US_TH) and, in addition, a directly preceding second type of signal edge is identified in the control signal (PWM).

11. Method according to one of Claims 2 to 10, wherein, in a first phase of switching-off of the semiconductor switch (HS1), actuation of the first driver switch (T1) by the first preset actuation current (IAS1) and starting of a third time measurement at the beginning of the first phase of switching-off in order to determine a third duration in the case of an identified, directly preceding second type of signal edge in the case of the control signal (PWM) takes place, and wherein the third time measurement is continued as long as the presently measured control connection voltage (US) does not fall below the reference control voltage (US_TH), and wherein, if the determined third duration exceeds a third preset maximum duration, the control connection (SHS) is coupled to the negative supply voltage connection (NA) via an electrical resistor (R1).

12. Method according to Claim 11, wherein, in a second phase of switching-off of the semiconductor switch (HS1), actuation of the first driver switch (T1) by the second preset actuation current (IAS2) and starting of a fourth time measurement at the beginning of the second phase of switching-off of the semiconductor switch (HS1) in order to determine a fourth duration in the event that the reference input voltage (UE_TH) is exceeded by the presently measured input connection voltage (UE) takes place, and wherein the fourth time measurement is continued as long as the presently measured control connection voltage (US) does not fall below the reference control voltage (US_TH), and wherein, if the determined fourth duration exceeds a fourth preset maximum duration, the control connection (SHS) is coupled to the negative supply voltage connection (NA) via an electrical resistor (R1).

13. Method according to Claim 12, wherein, in a third phase of switching-off of the semiconductor switch (HS1), actuation of the first driver switch (T1) by the first preset actuation voltage in the event of the presently measured control connection voltage (US) falling below the reference control voltage (US_TH) takes place.

14. Circuit arrangement (SA1) for actuating a controllable semiconductor switch (HS1) using a control signal, wherein the circuit arrangement (SA1) comprises the following features:
- an actuation unit (AE) for actuating the semiconductor switch (HS1) by controlled, phase-based switching-on and switching-off,
- a time measurement unit (ZME) for starting a time measurement at the beginning of at least one phase of the phase-based switching-on and switching-off in order to determine a duration, wherein the time measurement is continued until a phase following the at least one phase of the phase-based switching-on and switching-off begins,
- a comparison unit (VE3) for comparing the determined duration with a preset maximum duration,
wherein the actuation unit (AE) is designed to actuate the semiconductor switch (HS1) in such a way that the semiconductor switch (HS1) is switched to a switched-off operating state if the determined duration exceeds the preset maximum duration.

15. Circuit arrangement (SA1) according to Claim 14, wherein the semiconductor switch (HS1) has a control connection (SHS), an input current connection (EHS) and an output current connection (AHS) and is controllable via the control connection (SHS), and wherein the control signal is a pulse-width-modulated control signal (PWM), and wherein the circuit arrangement (SA1) additionally has the following features:
- a driver circuit unit having at least one controllable driver switch,
- a first comparison unit (VE1) for measuring an input connection voltage (UE) at the input current connection (EHS) of the semiconductor switch (HS1) and for comparing the measured input connection voltage (UE) with a reference input voltage (UE_TH),
- a second comparison unit (VE2) for measuring a control connection voltage (US) at the control connection (SHS) of the semiconductor switch (HS1) and for comparing the measured control connection voltage (US) with a reference control voltage (US_TH),
and wherein the actuation unit (AE) is designed to actuate the semiconductor switch (HS1) by controlled, phase-based switching-on and switching-off of the at least one driver switch.

## Revendications

1. Procédé d'excitation d'un commutateur à semiconducteur (HS1) commandable avec un signal de commande par mise en circuit et hors circuit par phases commandée, le procédé comprenant les étapes suivantes :
- démarrage d'une mesure de temps (ST_PH1_ON) au début d'au moins une phase de la mise en circuit et hors circuit par phases en vue de déterminer une durée (ST_PH2_ON), la mesure du temps se poursuivant jusqu'à ce qu'une phase qui suit l'au moins une phase de la mise en circuit et hors circuit par phases commence,
- comparaison de la durée déterminée à une durée maximale (ST_PH3_ON) prédéfinie,
- si la durée déterminée dépasse la durée maximale prédéfinie (ST_ERR_OFF), excitation du commutateur à semiconducteur (HS1) de telle sorte que le commutateur à semiconducteur (HS1) soit commuté dans un état de fonctionnement hors circuit (ST_UCE_FAIL).

2. Procédé selon la revendication 1, le commutateur à semiconducteur (HS1) possédant une borne de commande (SHS), une borne de courant d'entrée (EHS) ainsi qu'une borne de courant de sortie (AHS) et pouvant être commandé par le biais de la borne de commande (SHS) et le signal de commande étant un signal de commande modulé en largeur d'impulsions (PWM) et l'excitation du commutateur à semiconducteur (HS1) étant en outre effectuée au moyen d'une unité à circuit d'attaque, l'unité à circuit d'attaque possédant un premier commutateur d'attaque (T1) commandable, disposé entre la borne de commande (SHS) du commutateur à semiconducteur (HS1) et une première borne de tension d'alimentation négative (NA) et un deuxième commutateur d'attaque (T2) commandable disposé entre la borne de commande (SHS) du commutateur à semiconducteur (HS1) et une deuxième borne de tension d'alimentation positive (HA), et l'excitation du commutateur à semiconducteur (HS1) étant effectuée par une mise en circuit et hors circuit par phases commandée du premier commutateur d'attaque (T1) et du deuxième commutateur d'attaque (T2) et le procédé comprenant en outre les étapes suivantes :
- reconnaissance d'un premier type ou d'un deuxième type, différent du premier type, d'un front de signal au niveau du signal de commande (PWM),
- mesure d'une tension de borne d'entrée (UE) sur la borne de courant d'entrée (EHS) du commutateur à semiconducteur (HS1) ,
- comparaison de la tension de borne d'entrée (UE) mesurée avec une tension d'entrée de référence (UE_TH),
- mesure d'une tension de borne de commande (US) sur la borne de commande (SHS) du commutateur à semiconducteur (HS1),
- comparaison de la tension de borne de commande (US) mesurée avec une tension de commande de référence (US_TH),
- l'excitation du commutateur à semiconducteur (HS1) par mise en circuit et hors circuit par phases commandée du premier (T1) et du deuxième (T2) commutateur d'attaque étant effectuée en fonction
* du premier type ou du deuxième type reconnu, d'un front de signal directement suivant au niveau du signal de commande (PWM) et/ou
* du résultat de la comparaison entre la tension de borne d'entrée (UE) actuelle mesurée et la tension d'entrée de référence (UE_TH),
* du résultat de la comparaison entre la tension de borne de commande (US) actuelle mesurée et la tension de commande de référence (US_TH).

3. Procédé selon la revendication 2, l'excitation du commutateur à semiconducteur (HS1) par mise en circuit et hors circuit par phases commandée du premier (T1) et du deuxième (T2) commutateur d'attaque étant effectuée au choix avec une première tension d'excitation prédéfinie, une deuxième tension d'excitation prédéfinie, un premier courant d'excitation prédéfini (IAS1), un deuxième courant d'excitation prédéfini (IAS2), indépendant du premier courant d'excitation prédéfini (IAS1), un troisième courant d'excitation prédéfini (IAS3), un quatrième courant d'excitation prédéfini (IAS4), indépendant du troisième courant d'excitation prédéfini (IAS3), ou un cinquième courant d'excitation prédéfini (IAS5), plus faible que le premier courant d'excitation prédéfini (IAS1) et que le deuxième courant d'excitation prédéfini (IAS2).

4. Procédé selon la revendication 2 ou la revendication 3, selon lequel, dans une première phase d'une mise en circuit du commutateur à semiconducteur (HS1), une excitation du deuxième commutateur d'attaque (T2) avec le troisième courant d'excitation prédéfini (IAS3) et un démarrage d'une première mesure du temps au début de la première phase de la mise en circuit en vue de déterminer une première durée sont effectués en présence d'un premier type reconnu, directement suivant, du front de signal au niveau du signal de commande (PWM), et selon lequel la première mesure du temps se poursuit tant que la tension de borne de commande (US) actuelle mesurée ne dépasse pas la tension de commande de référence (US_TH) et selon lequel, dans le cas où la première durée déterminée dépasse une première durée maximale prédéfinie, le deuxième commutateur d'attaque (T2) est mis hors circuit et le premier commutateur d'attaque (T1) est excité avec le deuxième courant d'excitation prédéfini (IAS2).

5. Procédé selon la revendication 4, selon lequel, dans une deuxième phase de la mise en circuit du commutateur à semiconducteur (HS1), une excitation du deuxième commutateur d'attaque (T2) avec le quatrième courant d'excitation prédéfini (IAS4) et un démarrage d'une deuxième mesure du temps au début de la deuxième phase de la mise en circuit en vue de déterminer une deuxième durée sont effectués en cas de dépassement de la tension de commande de référence (US_TH) par la tension de borne de commande (US) actuelle mesurée, et selon lequel la deuxième mesure du temps se poursuit tant que la tension de borne d'entrée (UE) actuelle mesurée ne devient pas inférieure à la tension d'entrée de référence (UE_TH) et selon lequel, dans le cas où la deuxième durée déterminée dépasse une deuxième durée maximale prédéfinie, le deuxième commutateur d'attaque (T2) est mis hors circuit et le premier commutateur d'attaque (T1) est excité avec le cinquième courant d'excitation prédéfini (IAS5).

6. Procédé selon la revendication 4, selon lequel, dans la deuxième phase de la mise en circuit, la première mesure du temps se poursuit dans le cas où la tension de borne de commande (US) actuelle mesurée redevient inférieure à la tension de commande de référence (US_TH) et selon lequel, dans le cas où la première durée déterminée dépasse la première durée maximale prédéfinie, le deuxième commutateur d'attaque (T2) est mis hors circuit et le premier commutateur d'attaque (T1) est excité avec le deuxième courant d'excitation prédéfini (IAS2) .

7. Procédé selon la revendication 5 ou la revendication 6, selon lequel, dans une troisième phase de la mise en circuit du commutateur à semiconducteur (HS1), une excitation du deuxième commutateur d'attaque (T2) avec la deuxième tension d'excitation prédéfini est effectuée dans le cas où la tension de borne d'entrée (UE) actuelle mesurée devient inférieure à la tension d'entrée de référence (UE_TH), et selon lequel, dans la troisième phase de la mise en circuit, la tension de borne d'entrée (UE) est mesurée de manière répétitive et comparée avec la tension d'entrée de référence (UE_TH) et selon lequel, dans le cas où la tension de borne d'entrée (UE) mesurée de manière répétitive dépasse la tension d'entrée de référence (UE_TH), le deuxième commutateur d'attaque (T2) est mis hors circuit et le premier commutateur d'attaque (T1) est excité avec le cinquième courant d'excitation prédéfini (IAS5).

8. Procédé selon la revendication 7, selon lequel, dans la troisième phase de la mise en circuit, la deuxième mesure du temps se poursuit dans le cas où la tension de borne de commande (US) actuelle mesurée redevient inférieure à la tension de commande de référence (US_TH) et selon lequel, dans le cas où la première durée déterminée dépasse la première durée maximale prédéfinie, le deuxième commutateur d'attaque (T2) est mis hors circuit et le premier commutateur d'attaque (T1) est excité avec le deuxième courant d'excitation prédéfini (IAS2) .

9. Procédé selon la revendication 5 ou la revendication 7, selon lequel le premier commutateur d'attaque (T1) est excité avec le cinquième courant d'excitation prédéfini (IAS5) pendant une cinquième durée prédéfinie, et selon lequel, après avoir atteint la cinquième durée prédéfinie, la tension de borne de commande (US) est mesurée de manière répétitive et comparée avec la tension de commande de référence (US_TH).

10. Procédé selon la revendication 9, selon lequel la borne de commande (SHS) est connectée à la borne de tension d'alimentation négative (NA) par le biais d'une résistance électrique (R1) dans le cas où la tension de borne de commande (US) mesurée de manière répétitive ne devient pas inférieure à la tension de commande de référence (US_TH) après avoir atteint la cinquième durée, et selon lequel le premier commutateur d'attaque (T1) est excité avec la première tension d'excitation prédéfinie dans le cas où la tension de borne de commande (US) mesurée de manière répétitive ne devient pas supérieure à la tension de commande de référence (US_TH) et qu'en plus de cela un deuxième type de front de signal directement suivant est reconnu au niveau du signal de commande (PWM).

11. Procédé selon l'une des revendications 2 à 10, selon lequel, dans une première phase d'une mise hors circuit du commutateur à semiconducteur (HS1), une excitation du premier commutateur d'attaque (T1) avec le premier courant d'excitation prédéfini (IAS1) et un démarrage d'une troisième mesure du temps au début de la première phase de la mise hors circuit en vue de déterminer une troisième durée sont effectués en présence d'un deuxième type reconnu, directement suivant, du front de signal au niveau du signal de commande (PWM), et selon lequel la troisième mesure du temps se poursuit tant que la tension de borne de commande (US) actuelle mesurée ne devient pas inférieure à la tension de commande de référence (US_TH) et selon lequel, dans le cas où la troisième durée déterminée dépasse une troisième durée maximale prédéfinie, la borne de commande (SHS) est connectée à la borne de tension d'alimentation négative (NA) par le biais d'une résistance électrique (R1).

12. Procédé selon la revendication 11, selon lequel, dans une deuxième phase de la mise hors circuit du commutateur à semiconducteur (HS1), une excitation du premier commutateur d'attaque (T1) avec le deuxième courant d'excitation prédéfini (IAS2) et un démarrage d'une quatrième mesure du temps au début de la deuxième phase de la mise hors circuit du commutateur à semiconducteur (HS1) en vue de déterminer une quatrième durée sont effectués en cas de dépassement de la tension d'entrée de référence (UE_TH) par tension de borne d'entrée (UE) actuelle mesurée, et selon lequel la quatrième mesure du temps se poursuit tant que la tension de borne de commande (US) actuelle mesurée ne devient pas inférieure à la tension de commande de référence (US_TH) et selon lequel, dans le cas où la quatrième durée déterminée dépasse une quatrième durée maximale prédéfinie, la borne de commande (SHS) est connectée à la borne de tension d'alimentation négative (NA) par le biais d'une résistance électrique (R1).

13. Procédé selon la revendication 12, selon lequel, dans une troisième phase de la mise hors circuit du commutateur à semiconducteur (HS1), une excitation du premier commutateur d'attaque (T1) avec la première tension d'excitation prédéfinie est effectuée lorsque la tension de borne de commande (US) actuelle mesurée devient inférieure à la tension de commande de référence (US_TH).

14. Arrangement de circuit (SA1) destiné à l'excitation d'un commutateur à semiconducteur (HS1) commandable avec un signal de commande, l'arrangement de circuit (SA1) possédant les caractéristiques suivantes :
- une unité d'excitation (AE) destinée à exciter le commutateur à semiconducteur (HS1) par une mise en circuit et hors circuit par phases commandée,
- une unité de mesure de temps (ZME) destinée à démarrer une mesure de temps au début d'au moins une phase de la mise en circuit et hors circuit par phases en vue de déterminer une durée, la mesure du temps se poursuivant jusqu'à ce qu'une phase qui suit l'au moins une phase de la mise en circuit et hors circuit par phases commence,
- une unité de comparaison (VE3) destinée à comparer la durée déterminée à une durée maximale prédéfinie,
l'unité d'excitation (AE) étant configurée pour exciter le commutateur à semiconducteur (HS1) de telle sorte que le commutateur à semiconducteur (HS1) est commuté dans un état de fonctionnement hors circuit dans le cas où la durée déterminée dépasse la durée maximale prédéfinie.

15. Arrangement de circuit (SA1) selon la revendication 14, le commutateur à semiconducteur (HS1) possédant une borne de commande (SHS), une borne de courant d'entrée (EHS) ainsi qu'une borne de courant de sortie (AHS) et pouvant être commandé par le biais de la borne de commande (SHS) et le signal de commande étant un signal de commande modulé en largeur d'impulsions (PWM) et l'arrangement de circuit (SA1) possédant en outre les caractéristiques suivantes :
- une unité à circuit d'attaque qui possède au moins un commutateur d'attaque commandable,
- une première unité de comparaison (VE1) destinée à mesurer une tension de borne d'entrée (UE) sur la borne de courant d'entrée (EHS) du commutateur à semiconducteur (HS1) et à comparer la tension de borne d'entrée (UE) mesurée avec une tension d'entrée de référence (UE TH),
- une deuxième unité de comparaison (VE2) destinée à mesurer une tension de borne de commande (US) sur la borne de commande (SHS) du commutateur à semiconducteur (HS1) et à comparer la tension de borne de commande (US) mesurée avec une tension de commande de référence (US_TH),
et l'unité d'excitation (AE) étant configurée pour exciter le commutateur à semiconducteur (HS1) par mise en circuit et hors circuit par phases commandée de l'au moins un commutateur d'attaque.
